# EUROPÄISCHE PATENTSCHRIFT

(11) **EP 0 621 610 B1**
(45) Veröffentlichungstag und Bekanntmachung des Hinweises auf die Patenterteilung: **10.03.1999**
(21) Anmeldenummer: 94104647.6
(22) Anmeldetag: 24.03.1994
(51) Int. Cl.: H01B 12/04, H01L 39/24

(54) **Verfahren zur Wärmebehandlung von Hochtemperatur-Supraleitern in silberhaltigen Rohren**
Process for heat treatment of high temperature superconductors in silver-containing tubes
Procédé de traitement thermique des supraconducteurs à haute température dans des tubes contenant de l'argent

(30) Priorität: 21.04.1993 DE 4312935
(43) Veröffentlichungstag der Anmeldung: 26.10.1994
(73) Patentinhaber: Vacuumschmelze GmbH, 63450 Hanau (DE)
(72) Erfinder: Tenbrink, Johannes, Dr., D-63776 Mömbris (DE); Glücklich, Volker, D-63546 Hammersbach (DE); Puniska, Paul, D-63543 Neuberg (DE)
(74) Vertreter: Epping, Wilhelm, Dr.-Ing.

(56) Entgegenhaltungen:
- EP-A- 0 449 161
- WO-A-91/00622
- DE-A- 3 835 242
- US-A- 5 223 478
- DATABASE WPI Derwent Publications Ltd., London, GB; AN 92-395761 & JP-A-4 296 408 (HITACHI LTD) 20 Oktober 1992 & PATENT ABSTRACTS OF JAPAN Bd. 17, Nr. 115 (E-1330) 10 März 1993 & JP-A-04 296 408 (HITACHI LTD) 20 Oktober 1992
- APPLIED PHYSICS LETTERS, Bd. 61, Nr. 6, 10.August 1992 NEW YORK US, Seiten 717-719, W. ZHU ET AL
- PATENT ABSTRACTS OF JAPAN Bd. 17, Nr. 150 (E-1339) 25 März 1993 & JP-A-04 315 707 (SEMICONDUCTOR ENERGY LAB CO) 06 November 1992
- DATABASE WPI Derwent Publications Ltd., London, GB; AN 95-128118 & JP-A-07 053 218 (SUMITOMO METAL) , 28.Februar 1995

## Beschreibung

Die Erfindung betrifft ein Verfahren zur Wärmebehandlung von Hochtemperatur-Supraleitern (HTSL) des Bi-Sr-Ca-Cu-O-Systems, bei denen ein HTSL-Material bei einem Sauerstoffpartialdruck von weniger als 10 mbar geglüht wird.

Ein derartiges Verfahren zur Behandlung von pulverförmigem Supraleitermaterial mit der Zusammensetzung Bi1Sr1Ca1Cu2OY ist in JAPAN. JOURNAL OF APPLIED PHYS., Vol. 27, Nr. 8 (1988) Seiten L 1476 - L1479 beschrieben. Hier wurden aus dem Supraleiterpulver Pellets geformt und eine Glühbehandlung bei verschiedenem Sauerstoffpartialdruck in Argonatmosphäre durchgeführt. Es wurde untersucht, bei welchen Wärmebehandlungstemperaturen in Abhängigkeit vom Sauerstoffpartialdruck sich die Phase mit der höchsten supraleitenden Sprungtemperatur (high-Tc-temperature) von 107,5 K bildet. Dieser Effekt wurde bei einem Sauerstoffpartialdruck zwischen 35 und 77 mbar bei etwa 850 bis 860 °C am besten erreicht, da die Schmelztemperatur des Supraleitermaterials sich mit abnehmendem Sauerstoffpartialdruck ebenfalls verringert.

Weiterhin ist es aus APPLIED PHYSICS LETTERS 61 (6) vom 10.8.1992, Seiten 717 bis 719 bekannt, bei welchen Wärmebehandlungsbedingungen sich die Phase mit hoher Sprungtemperatur (das ist die Phase mit drei Cu-O-Ebenen pro halber Einheitszelle der Struktur), beispielsweise bei einem Material Bi₂SrCa₂Cu₃O₁₀ bildet. Hier wurde herausgefunden, daß sich die 110 K-Phase über einen weiten Temperaturbereich und Sauerstoffpartialdruck bildet. Als Bereiche für die Temperatur wurden 810 bis 890 °C und für den Sauerstoffpartialdruck 0,01 bis 0,75 atm, das sind 10 bis 750 mbar, gewählt. Es wurde beobachtet, daß diese Phase bei sehr niedrigem Sauerstoffpartialdruck, wie beispielsweise 10⁻⁵ atm, das sind 0,01 mbar, nicht stabil ist.

Weiterhin ist es aus der DE-OS 38 35 242 bekannt, langgestreckte, etwa drahtförmige Hochtemperatur-Supraleiter dadurch herzustellen, daß pulverförmiges Supraleitermaterial des Systems Y-Ba-Cu-O in einen Silbermantel eingebracht wird, daß der so gebildete Verbundleiter auf Endabmessung kalt verformt wird und daß durch eine Nachbehandlung in einem Temperaturbereich zwischen 880 und 900 °C unter Vakuum oder einer Schutzgasatmosphäre die bei der vorhergehenden Verformung verlorengegangenen Supraleitereigenschaften wieder eingestellt werden können. Im Anschluß an die Wärmebehandlung zwischen 880 und 900 °C findet dann eine Sauerstoffnachbehandlung statt, um genügend Sauerstoff von außen durch die Metallumhüllung in das Supraleitermaterial eindiffundieren zu lassen. Hierbei erhält man relativ hohe kritische Stromdichten zwischen 100 und 300 A/cm².

Aus VDI BERICHTE Nr. 733, 1989, Seiten 399 - 404 geht hervor, daß im Bi-Sr-Ca-Cu-O-System Drähte mit hoher kritischer Stromdichte hergestellt werden können. Durch eine zweistufige Glühung mit einem partiellen Schmelzen des HTSL-Kerns bei ca. 920 °C und einer anschließenden Langzeitglühung bei ca. 840 °C (jeweils an Luft) kann ein Material mit hohem Anteil der Bi₂ (Sr, Ca)₃ Cu₂ O₈₊ₓ -Phase hergestellt werden. Diese Phase enthält zwei Cu-O-Ebenen pro halber Einheitszelle. Die Phase mit der höchsten Sprungtemperatur mit drei Cu-Ebenen ist bei kreisrunden Leitern nicht vorteilhaft, da sie nur bei extrem flachen Supraleiterschichten das Erreichen einer nennenswerten Stromdichte gestattet.

In Database WPI, Derwent Publications Ltd., London, GB; AN 92-395761 & Patent Abstracts of Japan, vol. 17, No. 115 (E-1330) 10.03.1993 & JP-A-04 296 408 (Hitachi Ltd.) 20.10.1992 ist ein Hochtemperatursupraleiterdraht beschrieben, welcher aus Bi₂Sr₂CaCu₂AgOₓ und einer Hülle aus Silber besteht. Gemäß dem beschriebenen Verfahren wird das mit Supraleiterpulver gefüllte Rohr gezogen und wärmebehandelt. Vor der Glühbehandlung wird das Rohr mit einer Isolationsschicht versehen.

Die WO 91/00622 bezieht sich auf ein Verfahren zur Wärmebehandlung eines Hochtemperatursupraleiters des Bi(Pb)-Sr-Ca-Cu-O-Systems, bei dem während der Wärmebehandlung des Hochtemperatursupraleitermaterials ein Sauerstoffpartialdruck zwischen 40 und 70 mbar eingestellt wird.

Obgleich sich bei derartig hergestellten Verbundleitern im Prinzip gute stromleitende Eigenschaften ergeben, ist es schwierig, größere Längen von derartigen Verbundleitern fehlerfrei herzustellen, da gelegentlich die im wesentlichen aus Silber bestehende Umhüllung bei der hohen Temperatur von über 880°C stellenweise durchschmilzt. Dadurch tritt Supraleitermaterial aus, so daß sich Hohlräume bilden, die an den betreffenden Stellen des Leiters die Supraleitfähigkeit unterbrechen oder mindestens stark vermindern. Es hat sich herausgestellt, daß dieser Effekt auch wesentlich abhängig ist von der verwendeten Isolation um die Silberumhüllung, da beispielsweise eine Isolation mit Silicafasern das durch die Silberumhüllung austretende Supraleitermaterial wie ein Schwamm aufsaugt und dadurch die Bildung von Hohlräumen stark vergrößert.

Aufgabe der vorliegenden Erfindung ist es, das Verfahren zur Wärmebehandlung von Hochtemperatursupraleitern des Bi-Sr-Ca-Cu-O-Systems, bei dem ein HTSL-Material als Pulver in einem Rohr aus Silber oder einer Silberlegierung angeordnet wird und in diesem Zustand bei einer Temperatur zwischen 840 und 870°C unter einem Sauerstoffpartialdruck geglüht wird, bezüglich des angewendeten Sauerstoffpartialdrucks so zu optimieren, daß die Bildung von Hohlräumen im Rohr bedingt durch ein Durchschmelzen des Silberrohres stark vermindert oder gänzlich vermieden wird.

Diese Aufgabe wird unter Verwendung der Tatsache, daß bei vermindertem Sauerstoffpartialdruck auch der Schmelzpunkt des Supraleitermaterials sich vermindert, durch die Merkmale im Kennzeichen des Anspruchs 1 gelöst.

Vorteilhafte Weiterbildungen und Ergänzungen des Verfahrens sind in den Unteransprüchen beschrieben.

Die Vorgänge bei Auftreten einer Durchschmelzung der Metallhülle bei einem Supraleiter mit unterschiedlichen Isolationen sind in den Figuren 1 und 2 dargestellt. Die Figuren 3 bis 6 zeigen erreichte Stromdichten bei Proben von unterschiedlichen Leiteranordnungen.

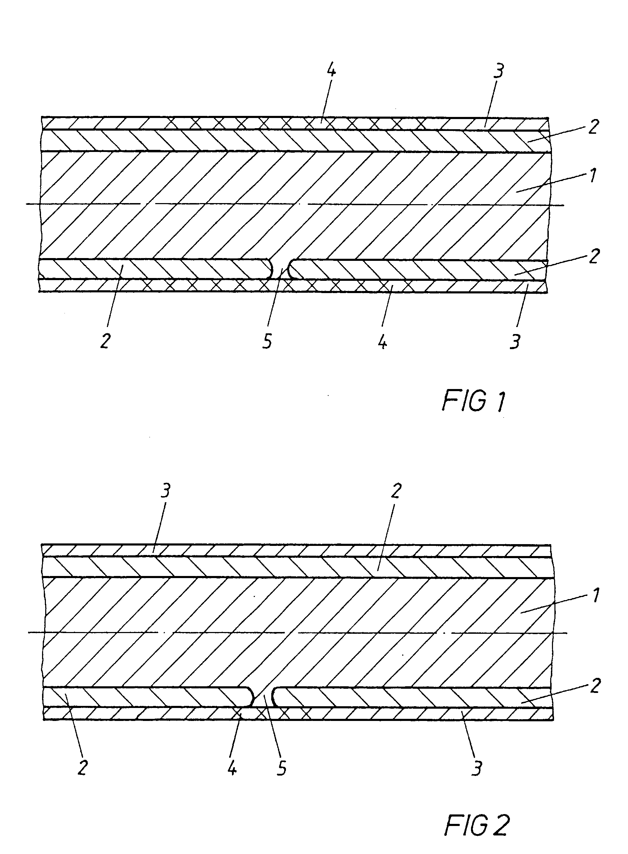

In Fig. 1 ist angenommen, daß eine Durchschmelzstelle bei einem Leiter mit Silberhülle und einer Silica-Faserisolation auftritt. Hier ist mit 1 der Kern aus Supraleitermaterial bezeichnet, der von einem Mantel 2 aus Silber umhüllt ist. Dieser Mantel wird wiederum von einer Faserisolation 3 aus Silicamaterial (SiO₂-Quarz) umschlossen. Wird dieser Leiter bei hoher Temperatur geglüht, so kann in Folge der Löslichkeit von Silber aus dem Mantel 2 im partiell geschmolzenen Material des Kerns 1 eine punktuelle Öffnung 5 auftreten. Da das Material des Kerns 1 bei dieser Temperatur teilweise geschmolzen ist, fließt es durch die Öffnung 5 und tränkt den kreuzschraffierten Bereich 4 der Isolation. Entsprechend dem durch die Öffnung 5 gelangten Material des supraleitenden Kerns ergibt sich im Inneren eine Verminderung von Supraleitermaterial und damit eine Unterbrechung der supraleitenden Eigenschaften im Bereich der durch die Durchschmelzung sich ergebenden Öffnung 5.

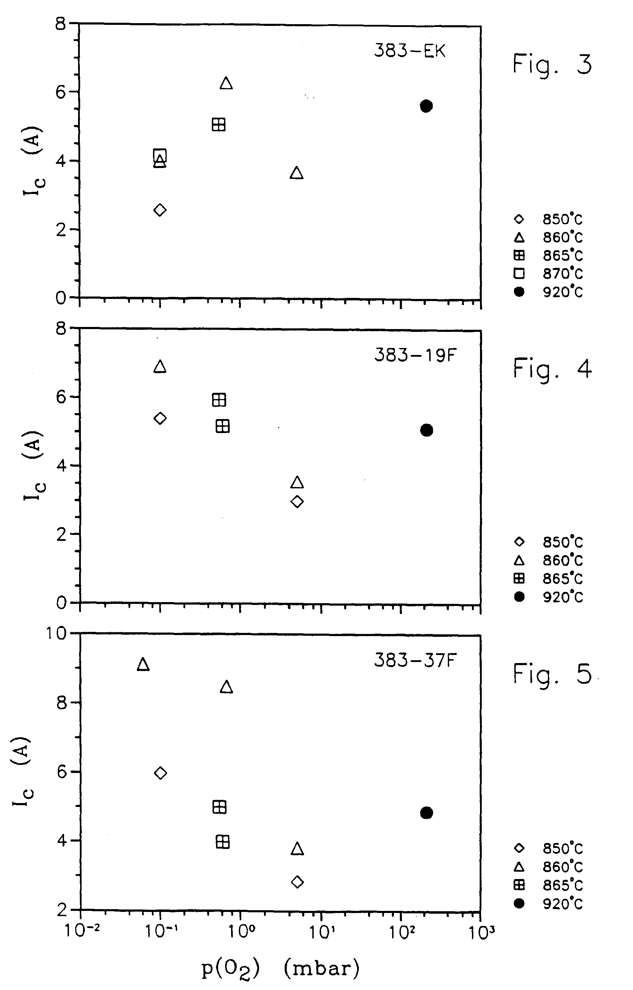

In Fig. 2 werden die Verhältnisse aufgezeigt, wenn eine Faserisolation mit einem Anteil von über 60 % an Aluminiumoxid (Al₂O₃) verwendet wird. Hier bewirkt das Aluminiumoxid, daß das Supraleitermaterial aus dem Kern 1 im Bereich der Öffnung 5 nur in geringen Mengen in die Faserisolation 3 eintreten kann, so daß nur wenig Material aus dem Kern austritt und sich dementsprechend nur eine geringe Schädigung der supraleitenden Eigenschaften ergibt. In den Fig. 3 bis 5 wird nun für einen Leiter mit 1 mm Durchmesser der erreichte kritische Strom Ic in Abhängigkeit von der Temperatur bei der durchgeführten Wärmebehandlung und in Abhängigkeit vom Sauerstoffpartialdruck pO₂ dargestellt. Die angegebenen Parameter der Wärmebehandlung beziehen sich jeweils auf die erste Stufe der Glühung. Die zweite Stufe bestand für alle Proben aus einer Langzeitglühung von über 100 h an Luft bei 840 °C.

Die eingetragenen Werte in Fig. 3 beziehen sich auf einen Einkernleiter; diejenigen in Fig. 4 auf einen Mehrkernleiter mit 19 Filamenten und die Werte in Fig. 5 auf einen Mehrkernleiter mit 37 Filamenten. In diesen Figuren ist der kritische Strom bei 77 K dargestellt, der sich ergibt, wenn die erste Stufe der Wärmebehandlung für eine Zeit von 0,5 h durchgeführt wird. Man sieht aus den Diagrammen, daß optimale Ergebnisse in Multifilamentleitern nach den Fig. 4 und 5 bei einem Sauerstoffpartialdruck von etwa 0,01 bis 8 mbar erreicht werden. Insbesondere beim Einkernleiter ist die erreichbare kritische Stromdichte trotzdem am höchsten, wenn unter Luft (bei einem Sauerstoffpartialdruck von etwa 210 mbar) die Wärmebehandlung durchgeführt wird (ausgefüllter schwarzer Kreis). Allerdings bewirkt die hierbei notwendige hohe Temperatur von 920 °C, daß fehlerfreie Ergebnisse nicht über große Längen zu erhalten sind. Die etwas niedrigeren kritischen Ströme beim Einkernleiter, wenn er unter Sauerstoffpartialdruck geglüht wird, sind aber immer noch ausreichend und insbesondere in Verbindung mit einer überwiegend aus Aluminiumoxid bestehenden Isolation eine Voraussetzung dafür, wenn man große Längen fehlerfreien Drahtes herstellen will. Bei Multifilamentleitern nach den Fig. 4 und 5 ergeben sich teilweise sogar bessere Stromwerte als bei der Wärmebehandlung unter Luft mit 210 mbar Sauerstoffpartialdruck. Auch hier beziehen sich die Angaben auf die Temperatur des Schmelzprozesses (1. Stufe). Die Langzeitglühung erfolgte für alle Proben bei 840 °C, über 100 h an Luft.

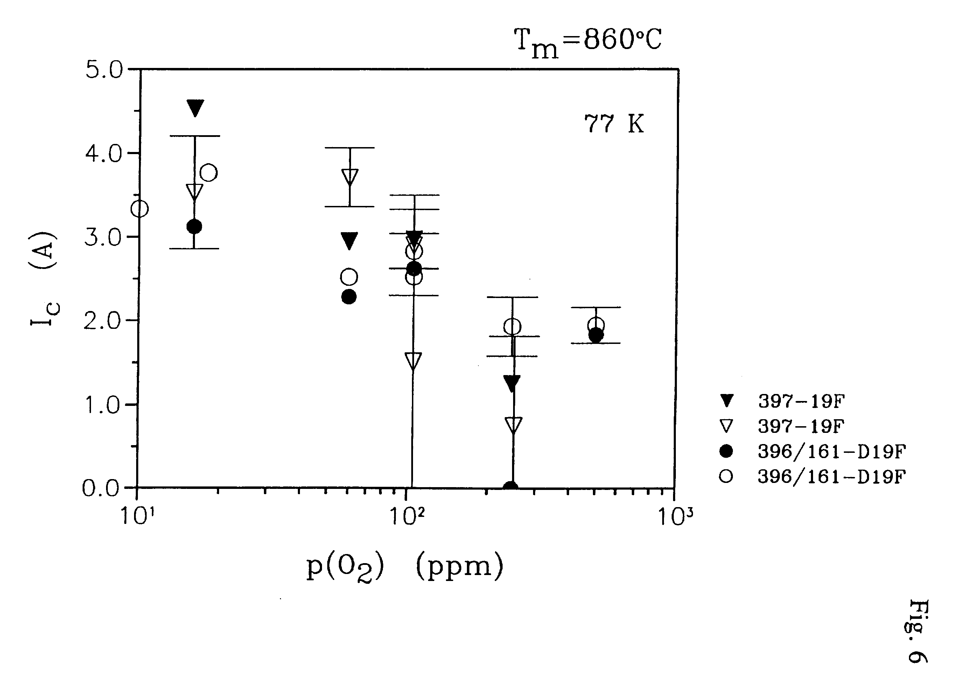

Fig. 6 zeigt Ergebnisse für den kritischen Strom bei 77 K für zwei verschiedene Supraleiter-Pulvermischungen, die mit 397 und 396/161 gekennzeichnet sind. Die Bezeichnung in Fig. 6 "19 F" bedeutet, daß es sich um einen Multifilamentleiter mit 19 Filamenten handelt. Bei den Meßwerten, die mit D gekennzeichnet sind, hatte der Leiter eine dispersionsgehärtete Hülle aus AgNiMg. Es wurden Proben aus kurzen Leiterstücken untersucht. Diese sind mit den offenen Symbolen (weißes Dreieck oder weißer Kreis) gekennzeichnet. Es wurden weiterhin längere als Testspulen aufgewickelte Leiter untersucht. Diese Meßwerte sind mit den geschlossenen Symbolen (schwarzes Dreieck oder schwarzer Kreis) in Fig. 6 gekennzeichnet. Alle Testspulen (Meßwerte mit geschlossenen Symbolen) waren mit einer Faserisolation isoliert, die einen Anteil von > 60 % Al₂O₃ besitzt.

Es zeigt sich aus den in Fig. 6 abzulesenden Meßwerten, daß der kritische Strom im Bereich von 10 bis 100 ppm (0,01 bis 0,1 mbar) Sauerstoff die höchsten Werte annimmt. Die Angabe Tₘ = 860 °C weist darauf hin, daß die erste Glühbehandlung mit partiell geschmolzenem Supraleitermaterial bei 860 °C erfolgte. Die anschließende Langzeitglühung erfolgte (wie bei den anderen Beispielen) bei 840 °C an Luft.

Einige der in den Diagrammen 3 bis 5 dargestellten Proben wurden auch bei 4,2 K und einem Magnetfeld von 9 T gemessen. Die Ergebnisse zeigt die angefügte Tabelle.

Als weiteres Beispiel wurde ein Draht mit 1 mm Durchmesser und 3,5 m Länge zu einer Wicklung verformt und bei 0,06 mbar einer Wärmebehandlung unterzogen, die ein partielles Aufschmelzen des Supraleitermaterials brachte. Hier erhielt man bei einer Glühtemperatur von 860 °C einen kritischen Strom von 5,44 A bei 77 K. Bei 4,2 K und einer Induktion von 9 T betrug der kritische Strom 33 A.

Bei der Wärmebehandlung von größeren Mengen Supraleitermaterial, wie z. B. Bi₂Sr₂Ca₁Cu₂O_{8, 2-8, 3} wird durch das teilweise Aufschmelzen des Supraleitermaterials "überschüssiger" Sauerstoff frei. Dieser aus dem Supraleitermaterial austretende Sauerstoff hat zur Folge, daß sich der Sauerstoffpartialdruck in dem Schutzgas, z. B. Ar, erhöht. Diese Erhöhung des Sauerstoffpartialdrucks kann zu schlechteren Ergebnissen des fertiggestellten Drahtes hinsichtlich der kritischen Stromdichte führen, so daß zur Sicherstellung eines gleichbleibenden Sauerstoffpartialdrucks p(O₂) dieser Sauerstoffpartialdruck während der Glühbehandlung ständig überwacht und durch Änderung des Sauerstoffgehaltes des einströmenden Gasgemisches ausgeglichen werden muß.

Um beispielsweise einen Sauerstoffpartialdruck von unter 10 mbar einzustellen, ist ein Gemisch aus Argon und Sauerstoff Ar/O₂ mit 10 bis 500 ppm O₂, vorzugsweise 10 bis 100 ppm O₂ notwendig. Beispielsweise wurde eine Wärmebehandlung eines Supraleiters mit einem Argon-Sauerstoffgasgemisch bei einem O₂-Partialdruck des Gasgemisches von ca. 90 ppm mit einer Durchflußrate von 50 l/h durchgeführt. Hierbei ergab sich eine vorübergehende deutliche Erhöhung des Sauerstoffpartialdrucks um bis zu 80 ppm für den Fall, daß das zuströmende Gasgemisch einen konstanten Sauerstoffpartialdruck aufwies.

Um diese vorübergehende Erhöhung des Sauerstoffpartialdrucks während der Wärmebehandlung auszuschließen, kann man versuchen, den Sauerstoffpartialdruck grundsätzlich während der Wärmebehandlung dadurch konstant zu halten, daß man den Sauerstoffpartialdruck des einströmenden Gases vorübergehend entsprechend vermindert. Dies ist aber bei größeren Drahtmengen und begrenztem Durchfluß des Gasgemisches nicht mehr möglich. Erfindungsgemäß wird daher als zusätzliche Maßnahme vorgeschlagen, zur Aufrechterhaltung des Sauerstoffpartialdrucks während der Wärmebehandlung zusätzlich ein Gasgemisch mit sauerstoffreduzierender Wirkung über das Supraleitermaterial zu leiten. Bei Verwendung eines Ar/O₂ - Gemisches zur Einstellung des Sauerstoffpartialdrucks kann beispielsweise ein Ar/H₂ - Gemisch mit 0,1 % H₂ zusätzlich zugeführt werden. Der in diesem Zusatzgemisch enthaltende Wasserstoff bindet bei entsprechender Dosierung den überschüssigen Sauerstoff, so daß durch Regelung des O₂ -Gehaltes der zugeführten Gasmenge in Verbindung mit einer Zumischung eines Gasgemisches aus Ar und H₂ auch bei größeren Supraleitermengen und begrenzter Durchflußmenge des Spülgases der beim partiellen Aufschmelzen des Supraleitermaterials frei werdende Sauerstoff in der Glühatmosphäre kompensiert wird und somit ein konstanter Sauerstoffpartialdruck während der gesamten Glühdauer eingehalten werden kann.

Mit der vorstehend beschriebenen Erfindung ist es also möglich, vergleichbare kritische Stromdichten bei Supraleitermaterial mit Silberhülle zu erzielen, ohne den Supraleiter bei der Wärmebehandlung Temperaturen von 900 °C oder mehr aussetzen zu müssen. Insbesondere in Verbindung mit einer Isolation, die mehr als 60 % Aluminiumoxid in den Fasern enthält, lassen sich auf diese Weise große Längen von fehlerfreien Verbunddrähten erzielen .

**TABELLE**

| **Einkernleiter (Ø 1 mm Draht)** | | | | | | |
|---|---|---|---|---|---|---|
| T (°C) | P(02) (mbar) | Ic (A) | | | | |
| 920 | 210 (Luft) | 40,1 | 47,0 | 42,3 | 45,9 | 63,0 |
| 860 | 5 (Ar/O₂) | 36,5 | | | | |
| 865 | 0,55 " | 28,0 | | | | |
| 870 | 0,1 " | 30,7 | | | | |
| 860 | < 0,68 | 33,3 | | | | |

| **Multifilamentleiter mit 37 Filamenten (Ø 1 mm Draht)** | | | | | | |
|---|---|---|---|---|---|---|
| T (°C) | P(02) (mbar) | Ic (A) | | | | |
| 920 | 210 (Luft) | 40,3 | 36,8 | 44,6 | 41,3 | 41,5 |
| 860 | 5 (Ar/O₂) | 31,9 | | | | |
| 865 | 0,55 " | 43,0 | | | | |
| 865 | 0,61 " | 43,0 | | | | |
| 860 | 0,06 " | 34,0 | | | | |
| 850 | 0,1 " | 36,1 | | | | |
| 860 | < 0,68 " | 41,7 | | | | |

| **Multifilamentleiter mit 19 Filamenten (Ø mm Draht)** | | | | | | |
|---|---|---|---|---|---|---|
| T (°C) | P(02) (mbar) | Ic (A) | | | | |
| 920 | 210 (Luft) | 37,3 | 43,0 | 41,3 | 40,1 | |
| 865 | 0,55 (Ar/O₂) | 46,8 | | | | |
| 865 | 0,61 " | 46,8 | | | | |
| 850 | 0,1 " | 42,1 | | | | |

## Patentansprüche

1. Verfahren zur Wärmebehandlung von Hochtemperatursupraleitern (HTSL) des Bi-Sr-Ca-Cu-O-Systems, bei denen ein HTSL-Material als Pulver in einem Rohr aus Silber oder einer Silberlegierung angeordnet wird und in diesem Zustand bei einer Temperatur zwischen 840 und 870°C unter einem Sauerstoffpartialdruck geglüht wird,
**dadurch gekennzeichnet,** daß der
Sauerstoffpartialdruck zwischen 0,01 und 5 mbar eingestellt wird.

2. Verfahren nach Anspruch 1,
**dadurch gekennzeichnet**, daß der
Sauerstoffpartialdruck zwischen 0,01 und 0,1 mbar eingestellt wird.

3. Verfahren nach Anspruch 1,
**dadurch gekennzeichnet**, daß
anschließend an die Wärmebehandlung mit niedrigem Sauerstoffpartialdruck eine Langzeitglühung bei wesentlich höherem Sauerstoffpartialdruck durchgeführt wird.

4. Verfahren nach Anspruch 1,
**dadurch gekennzeichnet,** daß der
Sauerstoffpartialdruck während der Wärmebehandlung durch Regelung des Sauerstoffanteils am zugeführten Gasgemisch konstant gehalten wird.

5. Verfahren nach Anspruch 1 oder 3,
**dadurch gekennzeichnet**, daß zur
Kompensation des Austretens des Sauerstoffs aus dem Supraleitermaterial bei der Wärmebehandlung zusätlich ein Spülgas mit einem sauerstoffreduzierendem Element über das Supraleitermaterial geleitet wird.

6. Verfahren nach Anspruch 5,
**dadurch gekennzeichnet**, daß als
sauerstoffreduzierendes Element dem Spülgas Wasserstoff zugesetzt wird.

7. Verfahren nach Anspruch 1,
**dadurch gekennzeichnet**, daß das Rohr
vor der Wärmebehandlung mit einer Isolation versehen wird, die aus Fasern besteht, deren Material zu mehr als 60 % aus Al₂O₃ hergestellt ist.

## Claims

1. Process for the heat-treatment of high-temperature superconductors (HTSCs) of the Bi-Sr-Ca-Cu-O system, in which an HTSC material is arranged as a powder in a tube made of silver or a silver alloy and, in this condition, annealed at a temperature of between 840 and 870°C under an oxygen partial pressure, characterized in that the oxygen partial pressure is set to between 0.01 and 5 mbar.

2. Process according to Claim 1, characterized in that the oxygen partial pressure is set to between 0.01 and 0.1 mbar.

3. Process according to Claim 1, characterized in that, subsequent to the heat-treatment at low oxygen partial pressure, slow annealing is carried at a substantially higher oxygen partial pressure.

4. Process according to Claim 1, characterized in that the oxygen partial pressure during the heat-treatment is kept constant by controlling the proportion of oxygen in the gas mixture supplied.

5. Process according to Claim 1 or 3, characterized in that, in order to compensate for the liberation of oxygen from the superconductor material during the heat-treatment, a flushing gas with an oxygen-reducing element is additionally passed over the superconductor material.

6. Process according to Claim 5, characterized in that hydrogen is added as the oxygen-reducing element in the flushing gas.

7. Process according to Claim 1, characterized in that, prior to the heat-treatment, the tube is provided with insulation which consists of fibres whose material is made to more than 60% from Al₂O₃.

## Revendications

1. Procédé de traitement thermique de supraconducteurs à haute température (SCHT) du système Bi-Sr-Ca-Cu-O, dans lequel on met un matériau SCHT sous forme de poudre dans un tube en argent ou en un alliage d'argent et on le calcine en cet état à une température comprise entre 840 et 870°C sous une pression partielle d'oxygène,
caractérisé en ce que la pression partielle d'oxygène est réglée entre 0,01 et 5 mbar.

2. Procédé suivant la revendication 1,
caractérisé en ce que la pression partielle d'oxygène est réglée entre 0,01 et 0,1 mbar.

3. Procédé suivant la revendication 1,
caractérisé en ce qu'à la suite du traitement thermique à une pression partielle d'oxygène basse, on effectue une calcination de longue durée à une pression partielle d'oxygène sensiblement plus élevée.

4. Procédé suivant la revendication 1,
caractérisé en ce que l'on maintient constante la pression partielle d'oxygène pendant le traitement thermique, en réglant la proportion d'oxygène dans le mélange gazeux affluent.

5. Procédé suivant la revendication 1 ou 3,
caractérisé en ce que pour compenser l'oxygène qui sort du matériau supraconducteur lors du traitement thermique, on envoie, en plus, sur le matériau supraconducteur un gaz de balayage ayant un élément qui réduit l'oxygène.

6. Procédé suivant la revendication 5,
caractérisé en ce que l'on ajoute au gaz de balayage de l'hydrogène servant d'élément réduisant l'oxygène.

7. Procédé suivant la revendication 1,
caractérisé en ce que l'on munit le tube avant le traitement thermique d'une isolation constituée de fibres dont le matériau est pour plus de 60 % de l'Al₂O₃.
